(19) **Europäisches Patentamt / European Patent Office / Office européen des brevets**

(11) **EP 1 172 901 B1**

(12) **EUROPEAN PATENT SPECIFICATION**

(45) Date of publication and mention
of the grant of the patent:
**03.01.2007 Bulletin 2007/01**

(51) Int Cl.:
***H01R 25/00*** *(2006.01)*

(21) Application number: **01305721.1**

(22) Date of filing: **02.07.2001**

(54) **Vehicle having an electrical connection box and electrical connection box for use in the vehicle**

Fahrzeug mit elektrischem Verbindungskasten und Verbindungskasten

Vehicule avec une boîte de connection électrique et cette boîte de connection

(84) Designated Contracting States:
**DE**

(30) Priority: **04.07.2000 JP 2000202235**
**04.07.2000 JP 2000202726**
**13.07.2000 JP 2000212979**
**13.07.2000 JP 2000213084**

(43) Date of publication of application:
**16.01.2002 Bulletin 2002/03**

(73) Proprietor: **Sumitomo Wiring Systems, Ltd.**
**Yokkaichi-City,**
**Mie, 510-8503 (JP)**

(72) Inventors:
• **Yuasa, Eriko c/o Intellectual Property Dep.**
**Sumito**
**Yokkaichi-city,**
**Mie 510-8503 (JP)**
• **Yamakawa, Shuji c/o Intellectual Property Dept.**
**Su**
**Yokkaichi-city,**
**Mie 510-8503 (JP)**
• **Kato, Shinshu c/o Intellectual Property Dept.**
**Sumi**
**Yokkaichi-city,**
**Mie 510-8503 (JP)**

(74) Representative: **Paget, Hugh Charles Edward et al**
**Mewburn Ellis LLP**
**York House**
**23 Kingsway**
**London WC2B 6HP (GB)**

(56) References cited:
**EP-A- 0 874 418** **US-A- 5 818 121**
**US-A- 5 823 798**

**Description**

**BACKGROUND OF THE INVENTION**

**Field of the Invention**

The present invention relates to a vehicle, such as an automobile, having an internal combustion engine, batteries powering electrical devices on the vehicle and an electrical connection box which is mounted on a vehicle, and also to electrical connection boxes for use in such a vehicle.

**Description of the Related Art**

Normally one secondary, i.e. rechargeable, battery having a rated voltage of 12V and a maximum nominal voltage of 14V is mounted on an automobile of the internal combustion engine type. A voltage up to the maximum voltage of 14V is applied from the battery to a circuit composed of bus bars and the like accommodated in the electrical connection box. The power supply is distributed by the internal circuit of the electrical connection box. The operation of electric/electronic component parts mounted on the vehicle is controlled through electric wires connected with the internal circuit.
On a goods vehicle, such as lorry or truck, a rated voltage of 24V and a maximum voltage of 28V are applied to a circuit, by a battery structure.
In recent years, electric/electronic component parts have been mounted in increasing numbers on a vehicle, and there is an increase in the electric current which is applied to one electric/electronic component part. For example, the electric power required to drive a fan is conventionally 130 watts, but has become 260 watts in recent years. At the rated voltage of 12V of the battery, it is impossible to operate suction and exhaust devices of an engine, an electromotive power steering, and the like devices, requiring a high voltage such as 36V. Therefore, they are mechanically operated by the driving force of the engine.
With the increase of the electric current applied to each electric/electronic component part, the diameter of the electric wires used has become larger.
Further, with rapid increase of the number of electric/electronic component parts, the number of electric wires has increased recently, which has increased the diameter of a wire harness comprising a bundle of electric wires. Consequently, the weight of the electric wires to be wired on a vehicle body has increased.
As described above, if the power supply from the battery is incapable of operating the suction and exhaust devices of the engine, they are mechanically operated. In this case, it is impossible to accomplish fine control of the operation of the suction and exhaust. Further much fuel is consumed, which pollutes the environment. Accordingly, it is preferable to operate the suction and exhaust devices of the engine and the like not mechanically by a cam but electrically by the power supply from the battery.
In the case where the circuit is so constructed that a voltage higher than 14V can be applied to the circuit of the electrical connection box composed of bus bars and the like from the battery having the rated voltage of 12V and the maximum voltage of 14V, it is possible to reduce the required electric current and thus the diameter of the electric wires and the size of a bundle of a plurality of electric wires (wire harness). Therefore, it is possible to reduce the weight of the electric wires.
Further, with the application of a high voltage to the circuit composed of bus bars and the like, it is possible to control the operation of the suction and exhaust devices, the power steering motor, and the like not mechanically or hydraulically but electrically. In this case, it is possible to accomplish fine control of the operation of suction and exhaust devices and the like. Further, fuel consumption can be reduced, which reduces pollution.
It is preferable to apply a high voltage of about 42V to the electromotive power steering motor, the suction and exhaust devices of the engine, the fan, other devices requiring a high voltage. On the other hand, in an automobile motorcar, it is preferable to apply the rated voltage of 12V (maximum voltage: 14V) to signal-generating devices of the electric/electrical components parts and coils of relays.
However, if the electrical connection box for distributing the power supply is provided with a circuit to which a low voltage up to the maximum voltage of 14V (28V in a truck) is applied and with a circuit to which a high voltage of about 42V is applied, a leak current is liable to be generated between the two circuits owing to the potential difference. Such a leak current may particularly occur if water or dirt enters the electrical connection box. The leak current is also liable to be generated in the circuit to which the high voltage of about 42V is applied.

**SUMMARY OF THE INVENTION**

It is an object of the present invention to prevent or reduce generation of a leak current in an electrical connection box, thereby permitting a circuit to which electric current having a low voltage is applied and a circuit to which electric current having a high voltage is applied.

According to the present invention, there is provided

a vehicle having

an internal combustion engine providing motive drive of the vehicle,

a first, low-voltage battery structure comprising at least one secondary battery (rechargeable battery), and having a nominal maximum output voltage selected from 14V and 28V,

a second, high-voltage battery structure comprising at least one secondary battery, and having a nominal maximum output voltage higher than that of the first battery structure and not more than 200V,

a plurality of electrical devices powered by the first and second battery structures, and

an electrical connection box containing an electrical circuit therein which effects connection between the first and second battery structures and the plurality of electrical devices,

the electrical circuit having an insulation plate and, fixed on one face of the insulation plate, at least one first bus bar (low voltage bus bar) connected to the first battery structure and at least one second bus bar (high voltage bus bar) connected to the second battery structure, whereby in operation the first and second bus bars are at different potentials,

wherein, in order to reduce risk of electrical leakage paths on the insulation plate, at least one of the following features is present:-

> (i) the first bus bar or bars and the second bus bar or bars are separated on the face of the insulation plate by an air insulation zone containing no bus bars and having a width in the range 1 to 30mm,
> (ii) an insulation wall is upstanding from the face of the insulation plate between the first bus bar or bars and the second bus bar or bars,
> (iii) the second bus bar or bars are at least partially embedded in insulating material selected from synthetic resin and grease, while the first bus bar or bars are exposed on the face of the insulation plate.

When feature (i) is present, preferably a plurality of the second bus bars are located at a central region of the face of the insulation plate as seen in plan view while a plurality of the first bus bars are located at a peripheral region of the face as seen in plan view.

In another aspect, the invention provides an electrical connection box adapted for use in a vehicle which has a first, low-voltage battery structure comprising at least one secondary battery, and having a nominal maximum output voltage selected from 14V and 28V, and a second, high-voltage battery structure comprising at least one secondary battery, and having a nominal maximum output voltage higher than that of said first battery structure and not more than 200V,

the electrical connection box containing an electrical circuit having an insulation plate and, fixed on one face of the insulation plate, at least one first bus bar adapted to be connected in use to the first battery structure and at least one second bus bar adapted to be connected in use to the second battery structure, whereby in operation the first and second bus bars are at different potentials,

wherein, in order to reduce risk of electrical leakage paths on the insulation plate, at least one of the following features is present:-

> (i) the first bus bar or bars and said the second bus bar or bars are separated on the face of the insulation plate by an air insulation zone containing no bus bars and having a width in the range 1 to 30mm,
> (ii) an insulation wall is upstanding from the face of the insulation plate between the first bus bar or bars and the second bus bar or bars,
> (iii) the second bus bar or bars are at least partially embedded in insulating material selected from synthetic resin and grease, while the first bus bar or bars are exposed on the face of the insulation plate.

When feature (i) described above in present, because the air insulation zone or area having the width of 1 - 30mm is interposed between the respective regions of the low voltage bus bars and the high voltage bus bars it is possible to prevent or minimize leak currents from being generated therebetween. As a result the low-voltage bus bars and the high-voltage bus bars can be arranged on one insulation plate in the same layer. It is unnecessary to place the low-voltage bus bars and the high-voltage bus bars in different and separate layers.

Accordingly, it is possible to reduce the size and thickness of the electrical connection box.

The number of the high-voltage bus bars is typically smaller than the number of the low-voltage bus bars. One or more high-voltage bus bars may be connected to one or more low-voltage bus bars through a relay mounted in the electrical connection box. As mentioned, preferably the high-voltage bus bars are disposed in the center of the insulation plate and the low-voltage bus bars are disposed at the periphery around the high-voltage bus bars. Thereby it is possible to dispose the high-voltage bus bars to be connected to a fuse proximately to a relay connection tab to be connected to the low-voltage bus bar, which allows handling and mounting of the bus bars to be accomplished efficiently.

In the central region in which the high-voltage bus bars are disposed, preferably adjacent high-voltage bus bars are spaced apart by a distance in the range of 1mm to 30mm, to avoid the risk that to leak currents are liable to be generated between the adjacent high-voltage bus bars.

When the feature (ii) described above is present, the height h and width w of the partition wall above the face of the insulation plate preferably satisfy the relations (1) and (2):

$$T < h \le 20t \qquad (1)$$

$$1.5 < w \le 20s \qquad (2)$$

where t is the uniform thickness of the first and second bus bars and s is the maximum width of the first and second bus bars, and h, w, t and s are all in mm. More preferably w and h satisfy the relations (3) and (4) :

$$t < h \le 10t \qquad (3)$$

$$1.5 < w \le 10s \qquad (4)$$

In this case, preferably a plurality of the first bus bars are located in a first region of the face adjacent a first one of opposite edges of the face, while a plurality of the second bus bars are located in a second region of the face which is spaced from the first region and is adjacent the other of said edges of said face.

Alternatively a plurality of the second bus bars may be located at a central region of the face of the insulation plate as seen in plan view while a plurality of the first bus bars are located at a peripheral region of the face as seen in plan view.

When feature (iii) described above is present, preferably an upstanding peripheral wall surrounds a region of the face of the insulation plate at which at least one second bus bar is located, and the insulating material is filled as a layer into a space bounded by the upstanding peripheral wall so as to cover and embed the second bus bar.

When feature (iii) is present, the insulating material is preferably selected from epoxy resin, two-part hardening resin and grease.

To fix the bus bars to the plate, a projection standing up from the insulation plate may be inserted into a hole formed on the bus bar and deformed (caulked) to fix the bus bar to a substrate resinous portion of the insulation plate.

It is preferably that the high voltage applied to the high-voltage bus bar or bars is 42V. In this case, it is easy to provide the voltage applied to the high-voltage bus bar to 42V by connecting in series three batteries each having a rated voltage of 12V (nominal maximum voltage: 14V) generally used in automobiles. Needless to say, it is possible to use a single battery having a maximum voltage of 42V. The reason why the high voltage to be applied to the high-voltage bus bar is set to 42V is partly because using a voltage close to or above 50V for the high-voltage bus bar may be more dangerous. The present inventors have conducted salt water experiments in order to ascertain the degree of risk when applying a voltage of 42V in an electrical junction box suitable for use in an automobile engine compartment, as follows:- 1ml of salt water was injected into each terminal hole of the casing of a junction box which had bus bars disposed inside. Electrical components such as relay, fuse, connectors etc. were mounted on the casing. A voltage of 42V was applied to bus bars of the junction box for 8 hours and suspended for 16 hours. This was repeated twice. There was initially no change to the bus bars and electrical components. However, after the third repetition, it was found that extra electric current passed between the bus bars generating heat and a portion of bus bars was melted. The heat also melted resin around bus bars such as an insulation plate, casing and resin portion of electrical components adjacent the casing.

Accordingly, it was confirmed that in consideration of normal use condition of an automobile, the application of the electric power at 42V to the electric/electronic component parts should not cause a problem.

## BRIEF DESCRIPTION OF THE DRAWINGS

Embodiments of the present invention will be described below by way of non-limitative example, with reference to drawings, in which:-

Fig. 1 is a diagram of elements of a vehicle which is an embodiment of the present invention.

Fig. 2 is a partial sectional view of an electrical connection box embodying the invention, accommodating a circuit, applicable in the vehicle of Fig. 1.

Fig. 3A is a plan view of the circuit of Fig. 2.

Fig. 3B is an enlarged sectional view showing a portion of the circuit of Fig. 2.

Fig. 4 is a partial sectional view of a second electrical connection box embodying the invention, applicable in the vehicle of Fig. 1, and containing a circuit.

Fig. 5A is a perspective view of a circuit of the box of Fig. 4.

Fig. 5B is an enlarged sectional view showing a portion of the circuit of Fig. 5A.

Fig. 6 is a perspective view illustrating the assembly of the circuit of Fig. 4.

Fig. 7 is a plan view of a modified form of the circuit of Fig. 4.

Fig. 8 is a partial sectional view of a third electrical connection box embodying the invention, applicable in the vehicle of Fig. 1, and containing a circuit.

Fig. 9A is a perspective view of the circuit of Fig. 8.

Fig. 9B is an enlarged sectional view showing a portion of the circuit of Fig. 9A.

Fig. 10 is a perspective view of a modified form of the circuit of Fig. 9A.

Fig. 11 is a partial sectional view of a fourth electrical connection box embodying the invention, applicable in the vehicle of Fig. 1, and containing a circuit.

Fig. 12A is a perspective view of the circuit of Fig. 11.

Fig. 12B is an enlarged sectional view of a portion of the circuit of Fig. 12A.

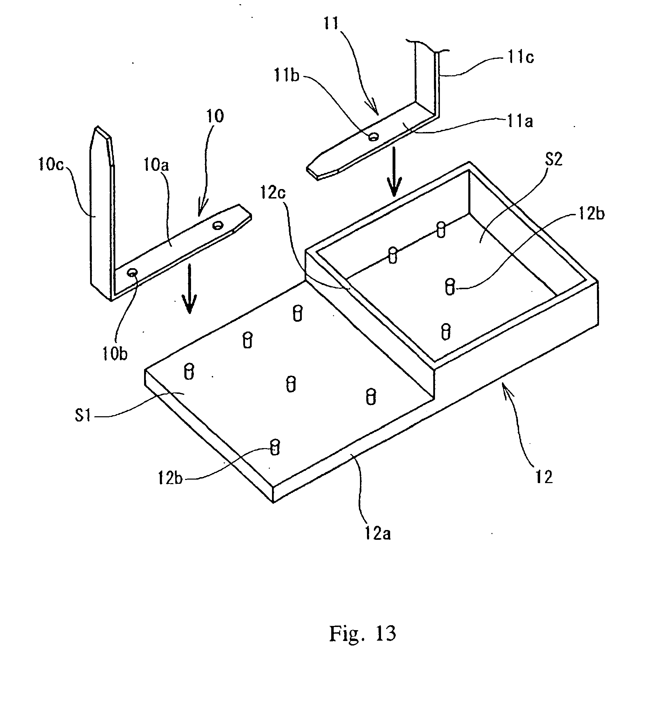

Fig. 13 is a perspective view showing a stage in the assembly of the circuit of Fig. 12A.

## DETAILED DESCRIPTION OF THE PREFERRED EMBODIMENTS

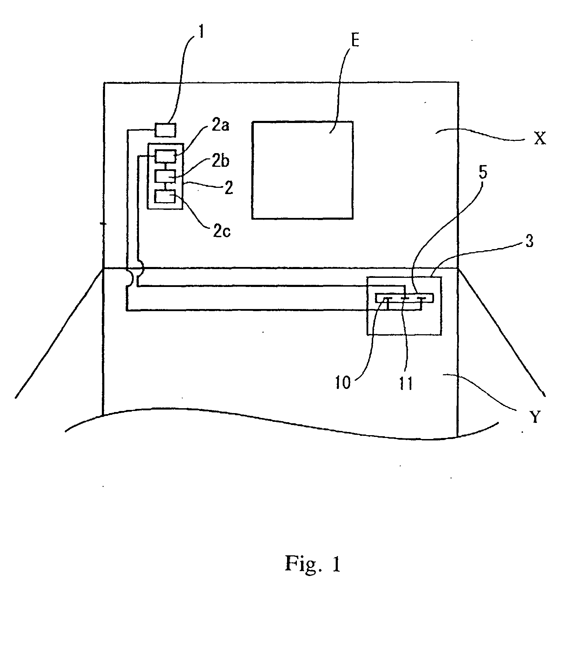

As schematically shown in Fig. 1, in an automobile to which the present invention is applied, an engine E mounted in an engine room X provides drive of the vehicle and generates electrical power, e.g. through an alternator (not shown). A low-voltage battery 1 and a high-voltage battery 2 are mounted in the engine room X, and are charged by the alternator. The low-voltage battery 1 consists of a general-purpose battery having a rated voltage 12V and a nominal maximum voltage of 14V. The high-voltage battery 2 consists of three battery units 2a, 2b, and 2c connected in series to generate a nominal maximum voltage of 42V. Each of the three battery unit, 2a, 2b, and 2c a the rated voltage of 12V. Such 12V rechargeable (secondary) battery units are conventional. Needless to say, it is possible to use a single battery having a maximum voltage of 42V. The batteries 1, 2 themselves and their connections to the alternator are conventional and need not be described in detail here.

The low-voltage battery 1 is connected to a low-voltage bus bar 10 accommodated in an electrical connection box 3 composed of a junction box mounted in the vehicle interior Y (or, depending on the vehicle, in the engine room) to apply a low voltage (maximum voltage: 14V) to the low-voltage bus bar 10.

The high-voltage battery 2 is connected to a high-voltage bus bar 11 accommodated in the same electrical connection box 3 to apply a high voltage (maximum voltage: 42V) to the high-voltage bus bar 11.

The load side of the high-voltage bus bar 11 is connected to electrical devices or actuators to operate them electromotively. The actuators (not shown) include a power steering motor, suction and exhaust devices of the engine, and like devices consuming high power. The load side of the low-voltage bus bar 10 is connected to appliances (not shown) such as sensors, lamps, and like devices consuming relatively low power, such as are typically provided in an automobile.

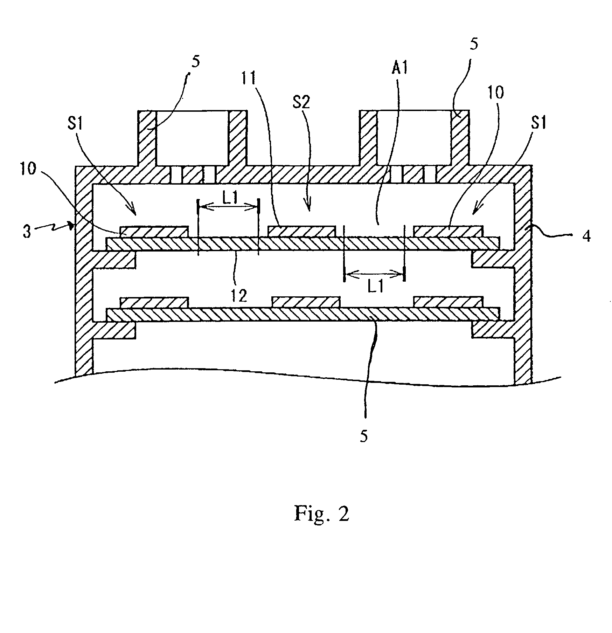

As shown in Fig. 2, the electrical connection box 3 accommodates a circuit having insulation plates 12 spaced one above another vertically, and mounted in a moulded plastics casing 4 which has sockets 6 for receiving connectors of wiring of the automobile.

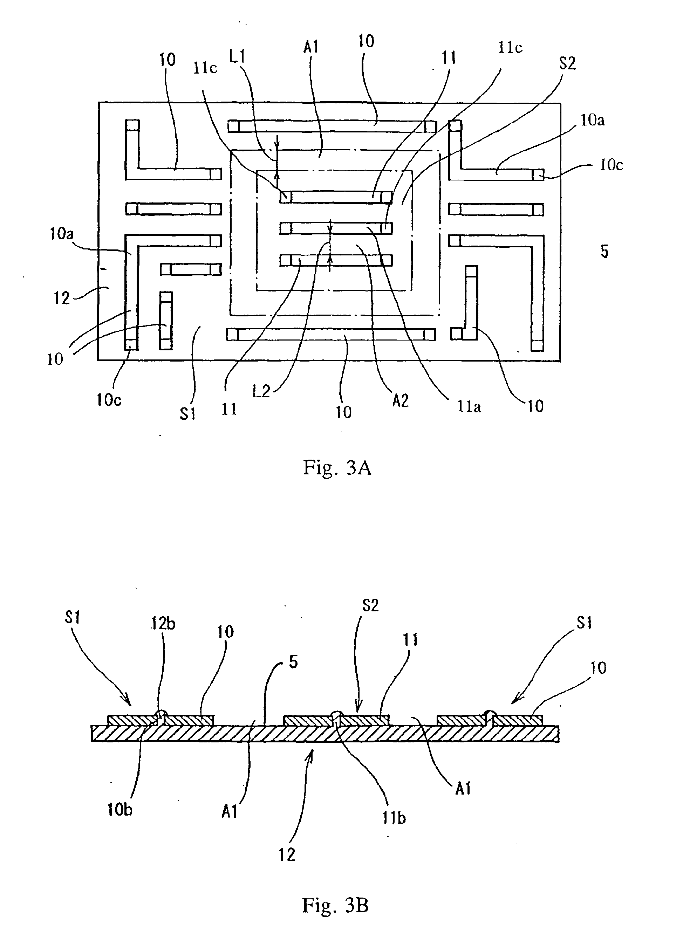

As shown in Fig. 3A, in the circuit, the face of the insulation plate 12 is partitioned into a peripheral section S1 and a central section S2. A plurality of low-voltage bus bars 10 are disposed in the peripheral section S1, whereas high-voltage bus bars 10 are disposed in the central section S2. An air insulation area A1, in the form of a surface region of the face to which bus bars are not fixed, is formed between the peripheral section S1 and the central section S2. The width L1 of the air insulation area A1 is in the range 1mm - 30mm. In the embodiment, the width L1 of the air insulation area A1 is 25mm. There is no other component or element intervening between the bus bars in this air insulation area.

In the central section S2 in which the high-voltage bus bar 10 are disposed, an air insulation area A2 having a width in the range 1mm - 30mm exists between each adjacent pair of the high-voltage bus bars 11. In the embodiment, the width L2 of the air insulation area A2 is 10mm.

As shown in Fig. 3B, bus bar-fixing spigots 12b project from the upper surface of the thin flat substrate which is the insulation plate 12, in a known manner. The bus bar-fixing spigots 12b are inserted into installing holes 10b, 11b formed on in strip-shaped horizontal portions 10a, 11a of each low-voltage bus bars 10 and the high-voltage bus bar 11. Then, the upper end of the spigot 12b is caulked, i.e. deformed, to fix the bus bars 10, 11 in position on the surface of the substrate 12.

As in conventional circuits, the horizontal portions 10a, 11a may be bent vertically to form upstanding tabs 10c, 11c on the low-voltage bus bars 10 and the high-voltage bus bars 11 respectively.

Directly or through relaying or transfer terminals, the tabs 10c, 11c are connected to terminals of external circuits through connectors provided on the outer surface of the electrical connection box 3 by fitting the terminals onto the tabs 10c, 11c. The tabs 10c, 11c may project into the connector sockets 5 shown in Fig. 2, as appropriate. For example, a terminal mounted at an end of an electric wire connected to the low-voltage battery 1 is fitted on the tab 10c at the power supply side of the low-voltage bus bar 10 and a terminal mounted at an end of an electric wire connected to the high-voltage battery 2 is fitted on the tab 11c at the power supply side of the high-voltage bus bar 11.

Although the low-voltage bus bar 10 and the high-voltage bus bar 11 having different operating voltages are disposed on the same plate 12 in the circuit 5, they are separately disposed in the sections S1 and S2, with the air insulation area A1 interposed between the sections S1 and S2. Thus, it is possible to prevent leak current from being generated between the low-voltage bus bars 10 and the high-voltage bus bars 11. Further, the air insulation area A2 is disposed in the section S2 in which the high-voltage bus bars 10 are adjacent. Thus, it is possible to prevent the leak current from being generated between the high-voltage bus bars 11.

The circuit 5 of the embodiment illustrated is intended for an automobile in which a battery of the rated voltage of 12V is mounted. But in the case where a maximum voltage of 28V is applied to a bus bar in an automobile or a truck, the bus bar to which the voltage of 28V is applied is the low-voltage bus bar and the bus bar to which the voltage of 42V is applied is the high-voltage bus bar. The construction of the circuit 5 disposed in the electrical connection box is in this case the same as that of the illustrated embodiment.

In the embodiment, the maximum voltage of 42V is applied to the high-voltage bus bar 11. But needless to say, a high voltage of 42V to 200V can be applied to the high-voltage bus bar 11, provided that the battery structure 2 is sufficiently light in weight and safety is ensured.

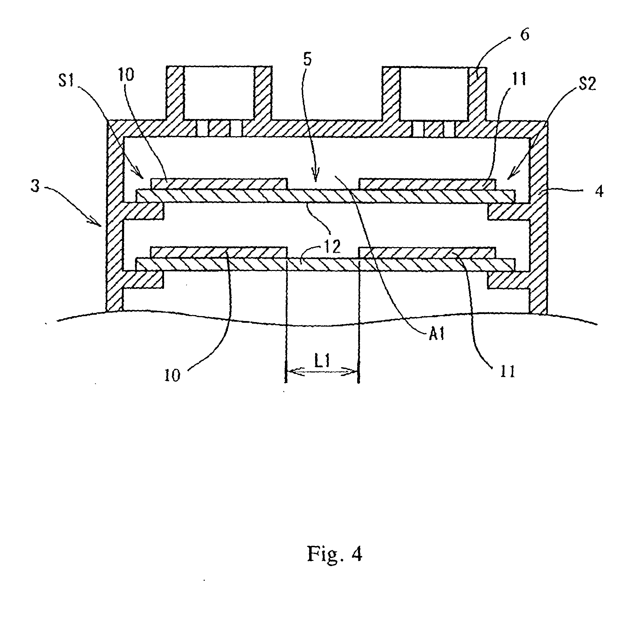

Figs. 4 to 6 show somewhat diagrammatically a second embodiment of the electrical connection box 3 of Fig. 1. The same reference numbers are used in these figures, and in all Figures described below, for parts which are the same as or similar to the parts in Figs. 1 to 3, and their description will not be fully repeated.

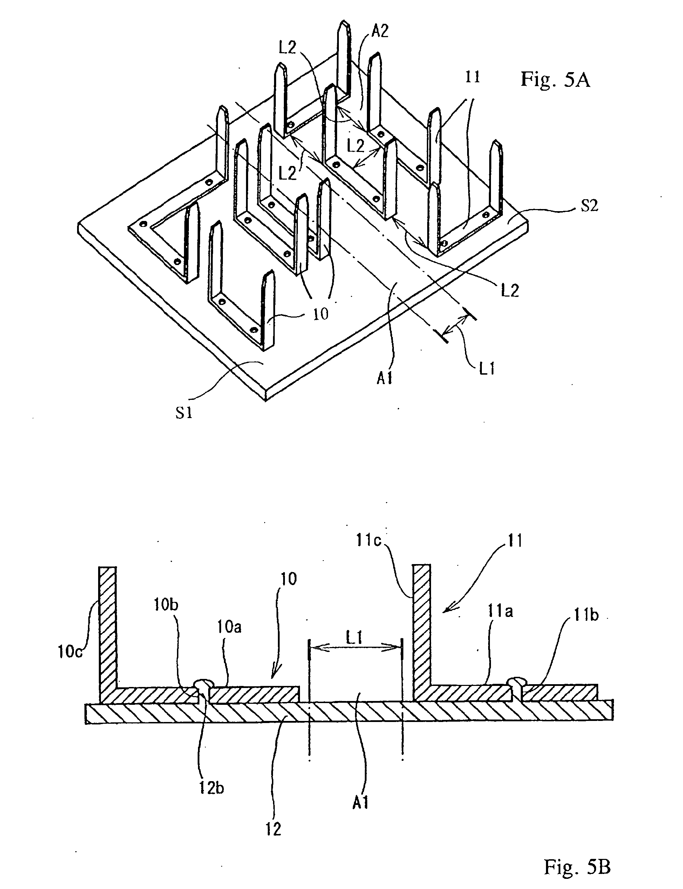

As shown in Fig. 4, the electrical connection box 3 accommodates a circuit 5 comprising insulating plates 12 which are stacked vertically in a moulded plastics casing 4 having connector sockets. As shown in Fig. 5, in the circuit, the face of each insulation plate 12 is divided into spaced regions or section S1 and S2 in the left-to-right direction thereof. All the low-voltage bus bars 10 are disposed in the section S1, whereas all the high-voltage bus bars 11 are disposed in the section S2. An empty air insulation area A1, to which no bus bars and no other components are fixed, is formed between the section S1 and S2. The width L1 of the air insulation area A1 is 1mm - 30mm, and in this embodiment is 20mm.

In the section S2 in which the high-voltage bus bars 10 are disposed, an air insulation area A2 having a width in the range of 1mm - 30mm is disposed between each adjacent pair of high-voltage bus bars 11. In this embodiment, the width L2 of the air insulation area A2 is 10mm.

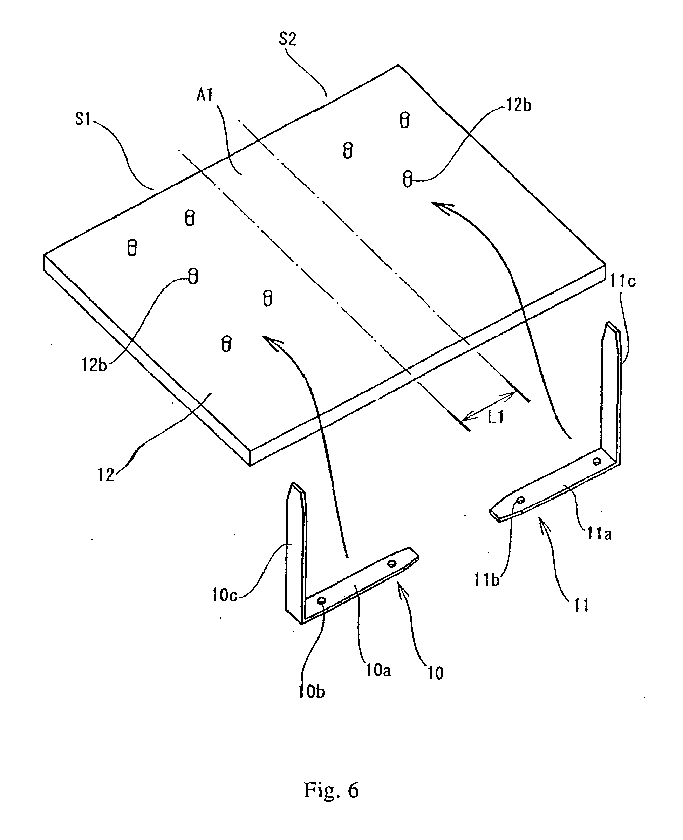

As shown in Figs. 5 and 6, bus bar-fixing spigots 12b project from the upper surface of a thin flat substrate 12a of the insulation plate 12, in a conventional manner, and are inserted into installing holes 10b, 11b formed on the strip-shaped horizontal portions 10a, 11a of the bus bars 10, 11.

Then, the upper ends of each of the spigots 12b are caulked or deformed to fix the bus bars to the surface of the substrate 12.

As in the case of Figs. 2 and 3, the bus bars 10, 11 are bent vertically to form tabs 10c, 11c, which directly or through relaying terminals are connected to terminals of external circuits through connectors mounted on the outer surface of the electrical connection box 3.

Although the low-voltage bus bars 10 and the high-voltage bus bars 11 having different applied voltages are disposed in the circuit 5 on the same plate 12, the low-voltage bus bars 10 and the high-voltage bus bars 11 are separately disposed in the sections S1 and S2, with the air insulation area A1 interposed between the sections S1 and S2. Thus, it is possible to prevent leak current from being generated between the low-voltage bus bars 10 and the high-voltage bus bars 11 to which different voltages are applied. Further, the air insulation areas A2 are provided in the section S2, to prevent leak current from being generated between the high-voltage bus bars 11.

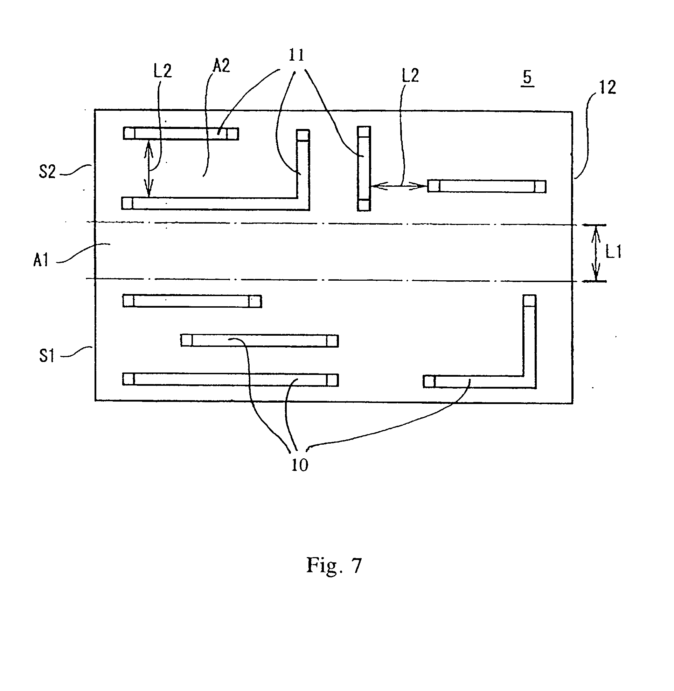

As shown in Fig. 7, it is possible alternatively to divide the insulation plate 12 of Fig. 5 into a front section S1 and a rear section S2 to dispose the low-voltage bus bars 10 collectively in the front section S1 and the high-voltage bus bars 11 collectively in the rear section S2.

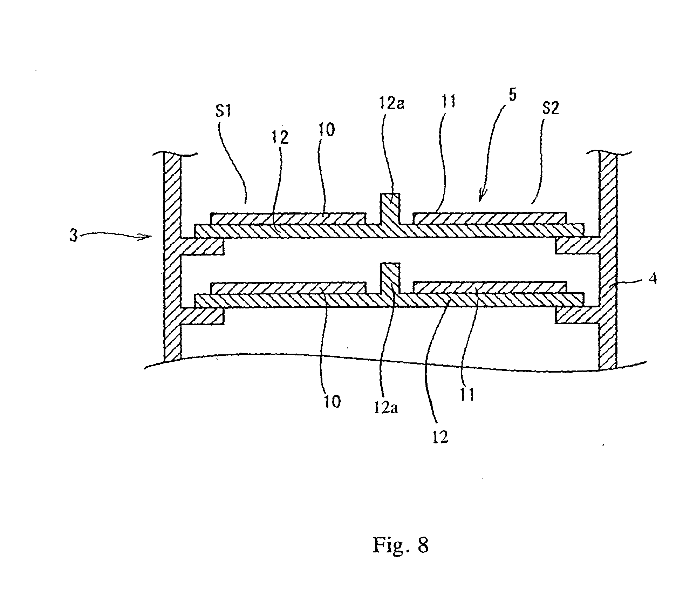

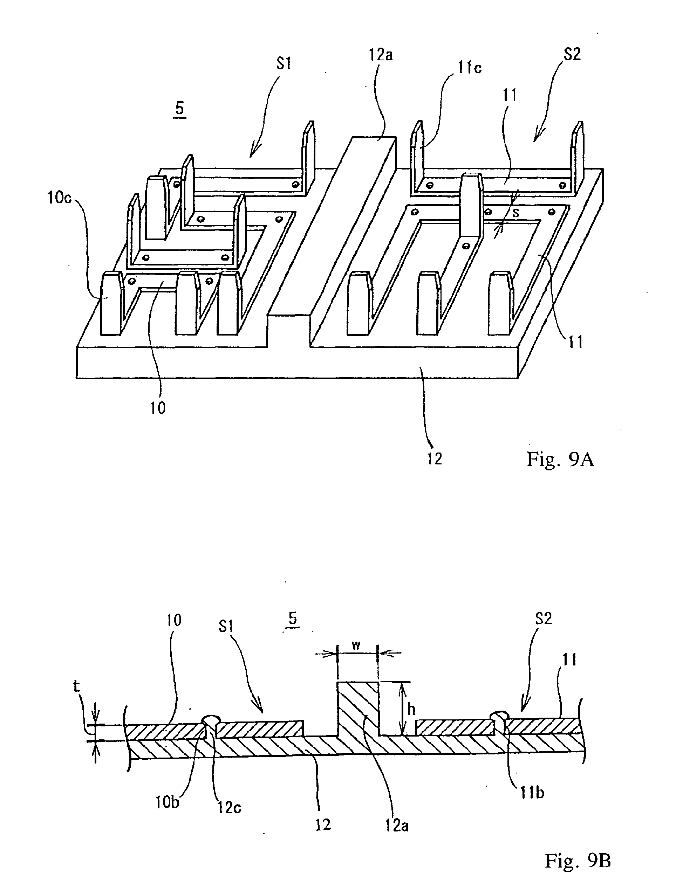

Figs. 8 and 9 show diagrammatically a third embodiment of the electrical junction box 3 of Fig. 1. As in the above embodiments, the electrical connection box 3 of Fig. 8 accommodates a circuit 5 comprising insulating plates stacked vertically in the moulded plastics casing 4. As shown in Fig. 9, in the circuit 5, each insulation plate 12 is partitioned into sections S1 and S2 in the left-to-right direction thereof. An electrically insulating partition wall 12a, integral with the plate 12, projects upwardly from the planar main body of the insulation plate 12 between the sections S1 and S2. All the low-voltage bus bars 11 are disposed in the section S1, whereas all the high-voltage bus bars 10 are disposed in the section S2, with the wall 12a interposed therebetween.

The wall 12a projects from the insulation plate 12 at the center in its left-to-right direction and extends over the whole length of the plate 12 in its front-to-back direction. Supposing that the thickness of each of the low-voltage bus bars 10 and the high-voltage bus bars 11 is t, the height h of the wall 12a is given by $t < h \leq 10t$. Supposing that the maximum width of each of the low-voltage bus bars 10 and the high-voltage bus bars 11 is s, the width w of the wall 12a is given by $1.5mm < w \leq 10s$.

As in the above embodiments spigots 12b projections from the upper surface of the plate 12 are inserted into holes 10b, 11b formed on horizontal portions 10a, 11a of the bus bars 10, 11 and caulked to fix the bus bars 11 to the surface of the plate 12.

The bus bar strips are bent vertically to form tabs 10c, 11c. These tabs function as described above.

In this embodiment, although the low-voltage bus bars 10 and the high-voltage bus bars 11 having different applied voltages are disposed in the circuit 5 on the same plate 12, the low-voltage bus bars 10 and the high-voltage bus bars 11 are separately disposed on the insulation plate 12, with the wall 12a interposed between the sections S1 and S2. Thus, it is possible to prevent or minimise leak currents from passing between the low-voltage bus bars 10 and the high-voltage bus bars 11.

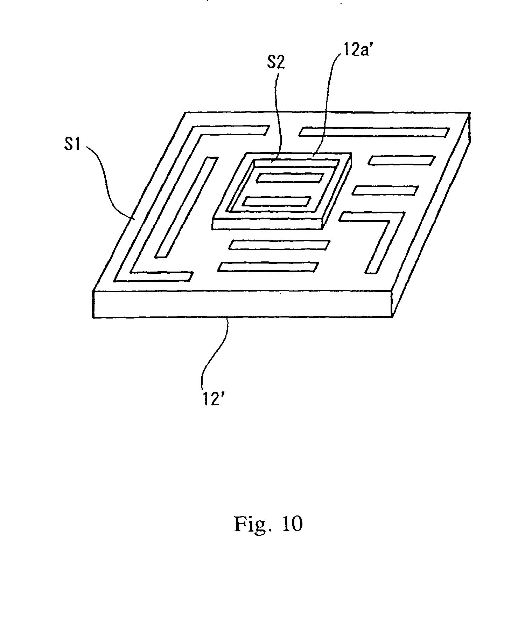

Fig. 10 shows a modification of this embodiment in which an insulation plate 12 of the circuit 5 is partitioned into a section S2 located in the central part of the insulation plate 12' and a peripheral section S1 surrounding the section S2. The high-voltage bus bars 11 are disposed in the section S2. The low-voltage bus bars 10 are disposed in the section S1. A insulation partitioning wall 12a' projects between the section S1 and the section S2, and extends in a separate shape around the central section S2.

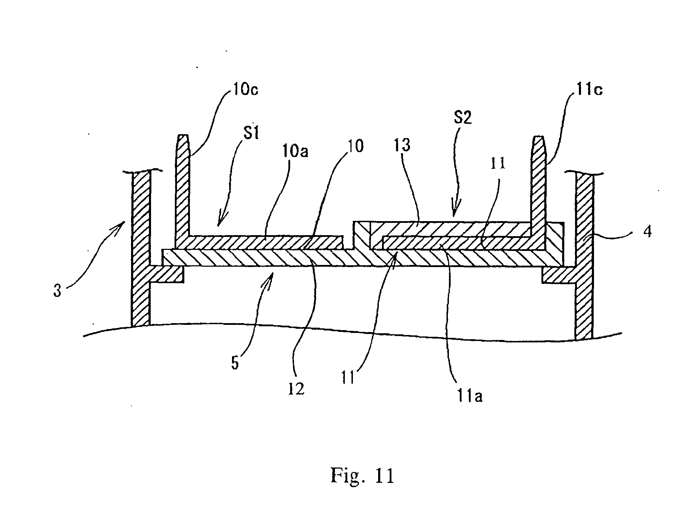

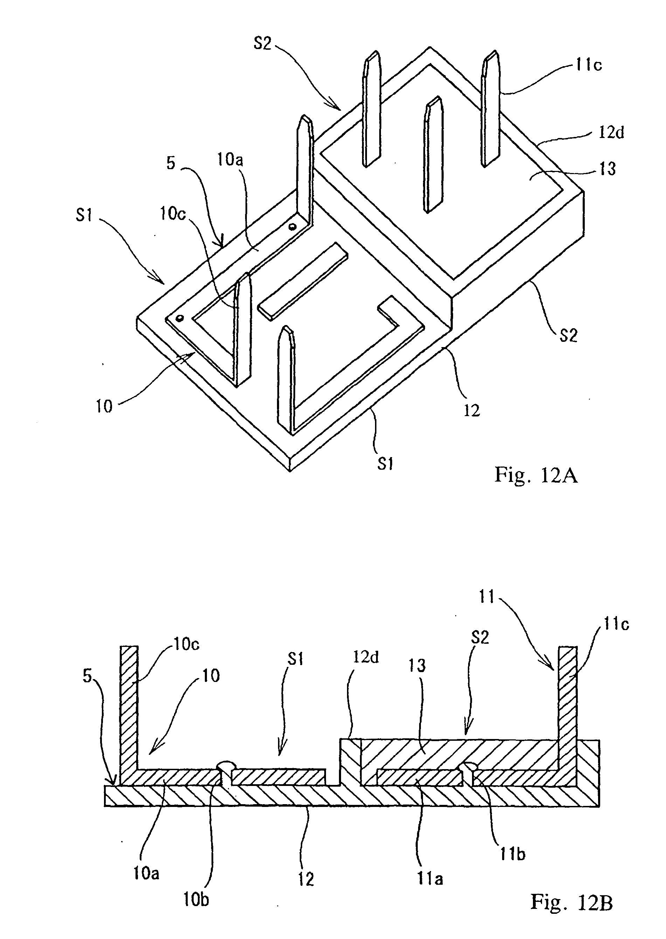

Figs. 11 and 12 show diagrammatically a fourth embodiment of the electrical junction box 3 of Fig. 1.

Fig. 11 shows a single insulation plate 12 of the circuit 5 mounted in the moulded plastics casing 4, but as in the other embodiments the circuit 5 may have a plurality of such plates. Figs 11 and 12 show a thin region or section S1 of the plate at one side and a thicker region or section S2 at the other side, having its top surface stepped up from that of section S1.

In the section S1, all the low-voltage bus bars 10 are fixed to the upper surface of the insulation plate 12 and exposed to the air. In the section S2, all the high-voltage bus bars 11 are fixed to the upper surface of the insulation plate 12 and are embedded in an insulating covering layer 13.

As in the other embodiments, spigots 12b project from the upper surface of a thin plate 12, and fix the bus bars in place. A peripheral wall 12d, integral with the insulation plate 12, surrounding the section S2, stands up the insulation plate 12.

In the section S2, after the high-voltage bus bars 11 are fixed to the insulation plate 12, epoxy resin, two-part hardening resin or grease is poured into the peripheral wall 12c to embed the high-voltage bus bars 11 in the insulating covering layer 13. Thus, the layer 13 is filled between the adjacent high-voltage bus bars 11, thus preventing a leak current from being generated between the adjacent high-voltage bus bars 11.

Epoxy resin, two-part hardening resin, and grease are preferable as the insulating material to be poured into the peripheral wall 12c. It is preferable to use resin having a melting point lower than that of the plate 12 and a thermal coefficient of shrinkage and a thermal coefficient of expansion similar to those of the substrate 12a. A hole may be formed in the section S2 of the plate 12 so that the resin fills into the hole, and is fixed to the substrate 12a with a high strength.

As in other embodiments the strip-shaped bus bars are bent vertically to form connection tabs 10c, 11c. The tabs 11c of the high-voltage bus bar 11 project upward from the upper surface of the resinous covering layer 13.

Although the low-voltage bus bars 10 and the high-voltage bus bars 11 having different applied voltages are disposed in the circuit 5 on the same plate 12, the low-voltage bus bars 10 and the high-voltage bus bars 11 are separately disposed on the plate 12, and the high-voltage bus bars 11 are embedded in the resinous covering layer 13. Thus, it is possible to prevent or minimise leak currents from being generated between the low-voltage bus bars 10 and the high-voltage bus bars 11, and between the adjacent high-voltage bus bars 11.

The present invention therefore makes it possible to reduce the diameter of electric wires and that of wire harnesses in a vehicle by reducing the amount of electric current, by applying a high voltage to circuits of the electrical connection box, while preventing leak currents from being generated between the low-voltage bus bars and the high-voltage bus bars. It is also possible to avoid leak current from being generated between the high-voltage bus bars.

While the invention has been illustrated by the exemplary embodiments described above, many equivalent modifications and variations will be apparent to those skilled in the art when given this disclosure. Accordingly, the exemplary embodiments of the invention set forth above are considered to be illustrative and not limiting. Various changes to the described embodiments may be made without departing from the scope of the invention.

**Claims**

1. A vehicle having
   an internal combustion engine (E) providing motive drive of the vehicle,
   a first, low-voltage battery structure (1) comprising at least one secondary battery, and having a nominal maximum output voltage selected from 14V and 28V,
   a second, high-voltage battery structure (2) comprising at least one secondary battery (2a, 2b, 2c), and having a nominal maximum output voltage higher than that of said first battery structure and not more than 200V,
   a plurality of electrical devices powered by said first and second battery structures, and
   an electrical connection box (3) containing an electrical circuit therein which effects connection between said first and second battery structures and said plurality of electrical devices,
   said electrical circuit having an insulation plate (12) and, fixed on one face of said insulation plate, at least one first bus bar (10) connected to said first battery structure and at least one second bus bar (11) connected to said second battery structure, whereby in operation said first and second bus bars are at different potentials,
   wherein, in order to reduce risk of electrical leakage paths on the insulation plate, at least one of the following features is present:-

   (i) the first bus bar or bars (10) and the second bus bar or bars (11) are separated on the face of the insulation plate by an air insulation zone containing no bus bars and having a width in the range 1 to 30mm,
   (ii) an insulation wall (12a, 12a') is upstanding from said face of said insulation plate between said at least one first bus bar and said at least one second bus bar,
   (iii) at least one second bus bar (11) is at least partially embedded in insulating material (13) selected from synthetic resin and grease, while the first bus bar or bars are exposed on the face of the insulation plate.

2. A vehicle according to claim 1, wherein said feature (i) is present, and a plurality of the second bus bars (11) are located at a central region (S2) of said face of said insulation plate as seen in plan view while a plurality of the first bus bars (10) are located at a peripheral region (S1) of said face as seen in plan view.

3. A vehicle according to claim 2, wherein at said central region (S2) of said face, said second bus bars are separated by air insulation zones.

4. A vehicle according to any one of claims 1 to 3,
   wherein said feature (i) is present, and a plurality of the second bus bars (11) are present at one region (S2) of the face of said insulation plate, adjacent pairs of said second bus bars (11) in said region (S2) being spaced from each other on said face by 1 to 30 mm.

5. A vehicle according to any one of claims 1 to 4, wherein said feature (ii) is present and the height h and width w of said partition wall (12a, 12a') above said face of said insulation plate satisfy the relations (1) and (2):

$$t < h \leq 20t \qquad (1)$$

$$1.5 < w \leq 20s \qquad (2)$$

   where t is the uniform thickness of said first and second bus bars and s is the maximum width of said first and second bus bars, and h, w, t and s are all in mm.

6. A vehicle according to claim 5, wherein w and h satisfy the relations (3) and (4):

$$t < h \leq 10t \qquad (3)$$

$$1.5 < w \leq 10s \qquad (4).$$

**7.** A vehicle according to claim 5 or 6, wherein said face of said insulation plate has a pair of opposite edges, and a plurality of said first bus bars are located in a first region of said face adjacent a first one of said edges while a plurality of said second bus bars are located in a second region of said face plate which is spaced from said first region and is adjacent the other of said edges of said face.

**8.** A vehicle according to claim 5 or 6, wherein a plurality of said second bus bars are located at a central region of said face of said insulation plate as seen in plan view while a plurality of said first bus bars are located at a peripheral region of said face as seen in plan view.

**9.** A vehicle according to any one of claims 1 to 8, wherein said feature (iii) is present and an upstanding peripheral wall (12d) surrounds a region (S2) of said face of said insulation plate at which the second bus bar or bars are located, and the insulating material (13) is filled as a layer into a space bounded by said upstanding peripheral wall (12d) so as to cover and embed said second bus bar.

**10.** A vehicle according to claim 9, wherein said insulating material is selected from epoxy resin, two-part hardening resin and grease.

**11.** A vehicle according to any one of claims 1 to 10, wherein said nominal maximum output voltage of said second battery structure is 42V.

**12.** An electrical connection box adapted for use in a vehicle as described in any one of claims 1 to 11 which has a first, low-voltage battery structure comprising at least one secondary battery, and having a nominal maximum output voltage selected from 14V and 28V, and a second, high-voltage battery structure comprising at least one secondary battery, and having a nominal maximum output voltage higher than that of said first battery structure and not more than 200V,

said electrical connection box (3) containing an electrical circuit having an insulation plate and, fixed on one face of said insulation plate, at least one first bus bar (10) adapted to be connected in use to said first battery structure and at least one second bus bar (11) adapted to be connected in use to said second battery structure, whereby in operation said first and second bus bars are at different potentials,

wherein, in order to reduce risk of electrical leakage paths on the insulation plate, at least one of the following features is present:-

(i) the first bus bar or bars (10) and the second bus bar or bars (11) are separated on the face of the insulation plate by an air insulation zone containing no bus bars and having a width in the range 1 to 30mm,

(ii) an insulation wall (12a, 12a') is upstanding from said face of said insulation plate between said at least one first bus bar and said at least one second bus bar,

(iii) at least one second bus bar (11) is at least partially embedded in insulating material (13) selected from synthetic resin and grease, while the first bus bar or bars are exposed on the face of the insulation plate.

**Patentansprüche**

**1.** Fahrzeug, aufweisend
einen Verbrennungsmotor bzw. eine Verbrennungskraftmaschine (E), welche einen Motorantrieb des Fahrzeugs zur Verfügung stellt,
eine erste Niederspannungs-Batteriestruktur (1), welche wenigstens eine sekundäre Batterie umfaßt und eine nominelle maximale Ausgangs- bzw. Ausgabespannung aufweist, welche aus 14 V und 28 V ausgewählt ist,
eine zweite Hochspannungs-Batteriestruktur (2), welche wenigstens eine sekundäre Batterie (2a, 2b, 2c) umfaßt und eine nominelle maximale Ausgangs- bzw. Ausgabespannung höher als diejenige der ersten Batteriestruktur und nicht mehr als 200 V aufweist,
eine Mehrzahl von elektrischen Vorrichtungen, welche durch die erste und zweite Batteriestruktur versorgt sind, und einen elektrischen Verbindungskasten (3), welcher eine elektrische Schaltung darin enthält, welche eine Verbindung zwischen der ersten und zweiten Batteriestruktur und der Mehrzahl von elektrischen Vorrichtungen bewirkt,
wobei die elektrische Schaltung eine Isolationsplatte (12) und, fixiert auf bzw. an einer Fläche bzw. Seite der Isolationsplatte, wenigstens eine erste Strom- bzw. Sammelschiene (10), welche mit der ersten Batteriestruktur verbunden ist, und wenigstens eine zweite Strom- bzw. Sammelschiene (11) aufweist, welche mit der zweiten Batteriestruktur verbunden ist, wodurch sich in einem Betrieb die erste und zweite Sammelschiene auf unterschiedlichen Potentialen befinden,

wobei, um ein Risiko von elektrischen Leckpfaden auf der Isolationsplatte zu reduzieren, wenigstens eines der folgenden Merkmale vorhanden ist: -

(i) die erste(n) Sammelschiene oder -schienen (10) und die zweite(n) Sammelschiene oder -schienen (11) sind auf der Fläche bzw. Seite der Isolationsplatte durch eine Luftisolationszone getrennt, welche keine Sammelschienen enthält und eine Breite in dem Bereich von 1 bis 30 mm aufweist,

(ii) eine Isolationswand (12a, 12a') ragt von der Fläche der Isolationsplatte zwischen der wenigstens einen ersten Sammelschiene und der wenigstens einen zweiten Sammelschiene auf,

(iii) wenigstens eine zweite Sammelschiene (11) ist wenigstens teilweise in ein isolierendes bzw. Isolationsmaterial (13) eingebettet, welches aus synthetischem bzw. Kunstharz und Fett bzw. Schmiere ausgewählt ist, während die erste(n) Sammelschiene oder -schienen auf bzw. an der Fläche der Isolationsplatte freigelegt ist bzw. sind.

2. Fahrzeug nach Anspruch 1, wobei das Merkmal (i) vorhanden ist, und eine Mehrzahl der zweiten Sammelschienen (11) an einem zentralen Bereich bzw. einer zentralen Region (S2) der Fläche der Isolationsplatte, wie in einer Draufsicht gesehen, angeordnet ist, während eine Mehrzahl der ersten Sammelschienen (10) an einem Umfangsbereich (S1) der Fläche, wie in einer Draufsicht gesehen, angeordnet ist.

3. Fahrzeug nach Anspruch 2, wobei an dem zentralen Bereich (S2) der Fläche die zweiten Sammelschienen durch Isolationszonen getrennt sind.

4. Fahrzeug nach einem der Ansprüche 1 bis 3, wobei das Merkmal (i) vorhanden ist, und eine Mehrzahl der zweiten Sammelschienen (11) an einem Bereich (S2) der Fläche der Isolationsplatte vorhanden ist, wobei benachbarte Paare der zweiten Sammelschienen (11) in dem Bereich (S2) voneinander auf bzw. an der Fläche um 1 bis 30 mm beabstandet sind.

5. Fahrzeug nach einem der Ansprüche 1 bis 4, wobei das Merkmal (ii) vorhanden ist, und die Höhe h und die Breite w der Trennwand (12a, 12a') über der Fläche der Isolationsplatte die Beziehungen (1) und (2) erfüllen:

$$t < h \leq 20t \qquad (1)$$

$$1{,}5 < w \leq 20s \qquad (2)$$

wo t die einheitliche Dicke der ersten und zweiten Sammelschienen ist und s die maximale Breite der ersten und zweiten Sammelschienen ist, und h, w, t und s alle in mm angegeben sind.

6. Fahrzeug nach Anspruch 5, wobei w und h die folgenden Beziehungen (3) und (4) erfüllen:

$$t < h \leq 10t \qquad (3)$$

$$1{,}5 < w \leq 10s \qquad (4).$$

7. Fahrzeug nach Anspruch 5 oder 6, wobei die Fläche der Isolationsplatte ein Paar von gegenüberliegenden bzw. entgegengesetzten Rändern bzw. Kanten aufweist, und eine Mehrzahl der ersten Sammelschienen in einem ersten Bereich der Fläche benachbart einer ersten der Kanten angeordnet ist, während eine Mehrzahl der zweiten Sammelschienen in einem zweiten Bereich der Flächenplatte angeordnet ist, welcher von dem ersten Bereich beabstandet ist und der anderen der Kanten der Flächen benachbart ist.

8. Fahrzeug nach Anspruch 5 oder 6, wobei eine Mehrzahl der zweiten Sammelschienen an einem zentralen Bereich der Fläche der Isolationsplatte, wie in einer Draufsicht gesehen, angeordnet ist, während eine Mehrzahl der ersten Sammelschienen an einem Umfangsbereich der Fläche, wie in einer Draufsicht gesehen, angeordnet ist.

9. Fahrzeug nach einem der Ansprüche 1 bis 8, wobei das Merkmal (iii) vorhanden ist und eine aufragende Umfangswand (12d) einen Bereich (S2) der Fläche der Isolationsplatte umgibt, bei welchem die zweite(n) Sammelschiene oder -schienen angeordnet ist bzw. sind, und das isolierende Material (13) als eine Schicht bzw. Lage in einen Raum gefüllt ist, welcher durch die aufragende Umfangswand (12d) begrenzt ist, um die zweite Sammelschiene zu bedecken und einzubetten.

10. Fahrzeug nach Anspruch 9, wobei das isolierende Material aus Epoxidharz, härtendem zweiteiligen bzw. Zwei-Komponenten-Harz bzw. Zwei-Komponenten-Aushärtungs-Harz und Fett gewählt ist.

11. Fahrzeug nach einem der Ansprüche 1 bis 10, wobei die nominelle maximale Ausgangsspannung der zweiten Batteriestruktur 42 V ist.

12. Elektrischer Verbindungskasten, welcher für eine Verwendung in einem Fahrzeug adaptiert ist, wie es in einem der Ansprüche 1 bis 11 beschrieben ist, welcher eine erste Niederspannungs-Batteriestruktur, welche wenigstens eine sekundäre Batterie umfaßt und eine nominelle maximale Ausgangs- bzw. Ausgabespannung aufweist, welche aus 14 V und 28 V ausgewählt ist, und eine zweite Hochspannungs-Batteriestruktur aufweist, welche wenigstens eine sekundäre Batterie umfaßt und eine nominelle maximale Ausgangs- bzw. Ausgabespannung höher als diejenige der ersten Batteriestruktur und nicht mehr als 200 V aufweist,
wobei der elektrische Verbindungskasten (3) eine elektrische Schaltung beinhaltet, welche eine Isolationsplatte und, fixiert auf einer Seite bzw. Fläche der Isolationsplatte, wenigstens eine erste Sammelschiene (10) welche adaptiert ist, um in einer Verwendung mit der ersten Batteriestruktur verbunden zu sein, und wenigstens eine zweite Strom- bzw. Sammelschiene (11) aufweist, welche adaptiert ist, um in einer Verwendung mit der zweiten Batteriestruktur verbunden zu sein, wodurch sich in einem Betrieb die erste und zweite Sammelschiene auf unterschiedlichen Potentialen befinden,
wobei, um ein Risiko von elektrischen Leckpfaden auf der Isolationsplatte zu reduzieren, wenigstens eines der folgenden Merkmale vorhanden ist: -

(i) die erste(n) Sammelschiene oder -schienen (10) und die zweite(n) Sammelschiene oder -schienen (11) sind auf der Fläche der Isolationsplatte durch eine Luftisolationszone getrennt, welche keine Sammelschienen enthält und eine Breite in dem Bereich von 1 bis 30 mm aufweist,
(ii) eine Isolationswand (12a, 12a') ragt von der Fläche der Isolationsplatte zwischen der wenigstens einen ersten Sammelschiene und der wenigstens einen zweiten Sammelschiene auf,
(iii) wenigstens eine zweite Sammelschiene (11) ist wenigstens teilweise in isolierendes bzw. Isolationsmaterial (13) eingebettet, welches aus synthetischem bzw. Kunstharz und Fett bzw. Schmiere ausgewählt ist, während die erste(n) Sammelschiene oder -schienen auf bzw. an der Fläche der Isolationsplatte freigelegt ist bzw. sind.

## Revendications

1. Véhicule comportant
un moteur à combustion interne (E) produisant la force d'entraînement du véhicule,
une première structure de batterie basse tension (1) comprenant au moins une batterie secondaire, et ayant une tension de sortie maximale nominale sélectionnée entre 14V et 28V,
une deuxième structure de batterie haute-tension (2) comprenant au moins une batterie secondaire (2a, 2b, 2c), et ayant une tension de sortie maximale nominale plus élevée que celle de ladite première structure de batterie et non supérieure à 200V,
plusieurs dispositifs électriques alimentés par lesdites première et seconde structures de batterie, et
une boîte de connexion électrique (3) contenant un circuit électrique qui effectue la connexion entre lesdites première et seconde structures de batterie et ladite pluralité de dispositifs électriques,
ledit circuit électrique ayant une plaque d'isolation (12) et, fixé sur une face de ladite plaque d'isolation, au moins une première barre bus (10) reliée à ladite première structure de batterie et au moins une seconde barre bus (11) reliée à ladite seconde structure de batterie, par quoi lors du fonctionnement, lesdites première et seconde barres bus sont à des potentiels différents,

dans lequel, pour réduire le risque de chemins de fuite électriques sur la plaque d'isolation, au moins l'une des caractéristiques suivantes est présente:

(i) la ou les premières barres bus (10) et la ou les secondes barres bus (11) sont séparées sur la face de la plaque d'isolation par une zone d'isolation à air ne contenant pas de barres bus et ayant une largeur dans la plage de 1 à 30 mm,

(ii) une paroi d'isolation (12a, 12a') se dresse depuis ladite face de ladite plaque d'isolation entre au moins une première barre bus précitée et au moins une seconde barre bus précitée,

(iii) au moins une seconde barre bus (11) est au moins partiellement noyée dans un matériau isolant (13) sélectionné parmi la résine synthétique et la graisse, pendant que la ou les premières barres bus sont exposées sur la face de la plaque d'isolation.

2. Véhicule selon la revendication 1, où ladite caractéristique (i) est présente, et une pluralité de secondes barres bus (11) se situent à une région centrale (S2) de ladite face de ladite plaque d'isolation telle que vue en plan pendant qu'une pluralité de première barres bus (10) se situe à une région périphérique (S1) de ladite face telle que vue en plan.

3. Véhicule selon la revendication 2, où à ladite région centrale (S2) de ladite face, lesdites secondes barres bus sont séparées par des zones d'isolation à air.

4. Véhicule selon l'une des revendications 1 à 3, où ladite caractéristique (i) est présente, et plusieurs secondes barres bus (11) sont présentes à une région (S2) de la face de ladite plaque d'isolation, des paires adjacentes desdites secondes barres bus (11) dans ladite région (S2) étant espacées les unes des autres sur ladite face de 1 à 30 mm.

5. Véhicule selon l'une des revendications 1 à 4, où ladite caractéristique (ii) est présente, et la hauteur h et largeur w de ladite paroi de séparation (12a, 12a') au-dessus de ladite face de ladite plaque d'isolation satisfont aux relations (1) et (2):

$$t < h \leq 20t \qquad (1)$$

$$1,5 < w \leq 20s \qquad (2)$$

où t indique l'épaisseur uniforme desdites première et seconde barres bus et s représente la largeur maximale desdites première et seconde barres bus, et h, w, t et s sont toutes en mm.

6. Véhicule selon la revendication 5, où w et h satisfont aux relations (3) et (4):

$$t < h \leq 10t \qquad (3)$$

$$1,5 < w \leq 10s \qquad (4)$$

7. Véhicule selon la revendication 5 ou 6, où ladite face de ladite plaque d'isolation présente une paire de bords opposés, et plusieurs desdites premières barres bus sont localisées dans une première région de ladite face adjacente à un premier desdits bords, alors qu'une pluralité desdites secondes barres bus sont localisées dans une seconde région de ladite plaque de face qui est espacée de ladite première région et qui est adjacente à l'autre desdits bords de ladite face.

8. Véhicule selon la revendication 5 ou 6, où plusieurs desdites secondes barres bus se situent à une région centrale de ladite face de ladite plaque d'isolation telle que vue en plan tandis que plusieurs desdites premières barres bus se situent à une région périphérique de ladite face telle que vue en plan.

9. Véhicule selon l'une des revendications 1 à 8, où ladite caractéristique (iii) est présente, et une paroi périphérique verticale (12d) entoure une région (S2) de ladite face de ladite plaque d'isolation à laquelle la ou les secondes barres bus se situent, et le matériau d'isolation (13) est introduit comme une couche dans un espace délimité par ladite paroi périphérique verticale (12d) de manière à couvrir et à noyer ladite seconde barre bus.

10. Véhicule selon la revendication 9, où ledit matériau d'isolation est sélectionné parmi la résine époxy, la résine de durcissement en deux parties et la graisse.

11. Véhicule selon l'une des revendications 1 à 10, où ladite tension de sortie maximale nominale de ladite seconde structure de batterie est de 42V.

12. Boîte de connexion électrique apte à être utilisée dans un véhicule tel que décrite dans l'une quelconque des revendications 1 à 11, qui possède une première structure de batterie basse tension comprenant au moins une batterie secondaire, et ayant une tension de sortie maximale nominale sélectionnée entre 14V et 28V, et une seconde structure de batterie haute tension comprenant au moins une batterie secondaire et ayant une tension de sortie maximale nominale plus élevée que celle de ladite première structure de batterie et non supérieure à 200V,
ladite boîte de connexion électrique (3) contenant un circuit électrique ayant une plaque d'isolation et, fixée sur une face de ladite plaque d'isolation, au moins une première barre bus (10) apte à être reliée en utilisation à ladite première structure de batterie et au moins une seconde barre bus (11) apte à être reliée en cours d'utilisation à ladite seconde structure de batterie, par quoi lors du fonctionnement, lesdites première et seconde barres bus sont à des potentiels différents,
où, pour réduire un risque de chemin de fuite électrique sur la plaque d'isolation, au moins l'une des caractéristiques suivantes est présente:

(i) la ou les premières barres bus (10) et la ou les secondes barres bus (11) sont séparées sur la face de la plaque d'isolation par une zone d'isolation à air ne contenant pas de barres bus et ayant une largeur dans la plage de 1 à 30mm,
(ii) une paroi d'isolation (12a, 12a') se dresse depuis ladite face de ladite plaque d'isolation entre au moins une première barre bus précitée et au moins une seconde barre bus précitée,
(iii) au moins une seconde barre bus (11) est au moins partiellement noyée dans du matériau d'isolation (13) sélectionné parmi la résine synthétique et la graisse, tandis que la ou les premières barres bus sont exposées sur la face de la plaque d'isolation.

Fig. 1

Fig. 2

Fig. 3A

Fig. 3B

Fig. 4

Fig. 5A

Fig. 5B

Fig. 6

Fig. 7

Fig. 8

Fig. 9A

Fig. 9B

S2

12a'

S1

12'

Fig. 10

Fig. 11

Fig. 12A

Fig. 12B

Fig. 13